(19) Europäisches Patentamt / European Patent Office / Office européen des brevets

(11) **EP 3 959 467 B1**

(12) **FASCICULE DE BREVET EUROPEEN**

(45) Date de publication et mention de la délivrance du brevet:
**03.07.2024 Bulletin 2024/27**

(21) Numéro de dépôt: **20719204.8**

(22) Date de dépôt: **21.04.2020**

(51) Classification Internationale des Brevets (IPC):
*F21S 41/16* (2018.01)  *F21S 41/176* (2018.01)
*F21S 41/20* (2018.01)  *F21S 41/141* (2018.01)
*G02B 26/10* (2006.01)  *H01S 5/00* (2006.01)

(52) Classification Coopérative des Brevets (CPC):
**F21S 41/14; F21S 41/16; F21S 41/176;**
**F21S 41/285; G02B 26/101;** H01S 5/0071;
H01S 5/0087

(86) Numéro de dépôt international:
**PCT/EP2020/061036**

(87) Numéro de publication internationale:
**WO 2020/216728 (29.10.2020 Gazette 2020/44)**

(54) **MODULE LUMINEUX**

LICHTMODUL

LIGHT MODULE

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **26.04.2019 FR 1904432**

(43) Date de publication de la demande:
**02.03.2022 Bulletin 2022/09**

(73) Titulaire: **Valeo Vision**
**93012 Bobigny Cedex (FR)**

(72) Inventeur: **ALBOU, Pierre**
**93012 BOBIGNY Cedex (FR)**

(74) Mandataire: **Valeo Visibility**
**Service Propriété Industrielle**
**c/o Valeo Vision**
**34, rue Saint André**
**93012 Bobigny (FR)**

(56) Documents cités:
EP-A1- 2 963 476      EP-A1- 3 203 305
WO-A1-2019/053053    US-A1- 2018 038 558

**Description**

DOMAINE TECHNIQUE DE L'INVENTION

L'invention concerne le domaine des modules lumineux et des dispositifs d'éclairage et/ou de signalisation. Elle trouve pour application particulièrement avantageuse le domaine des véhicules automobiles.

ÉTAT DE LA TECHNIQUE

Les projecteurs de véhicule automobile sont munis d'un ou de plusieurs modules lumineux agencés dans un boîtier fermé par une glace de manière à obtenir un ou plusieurs faisceaux d'éclairage et/ou de signalisation à la sortie du projecteur. De façon simplifiée, un module lumineux du boîtier comprend notamment une source de lumière qui émet un faisceau lumineux, un système optique comportant une ou plusieurs lentilles et, dans certains cas, un élément optique, par exemple un réflecteur, pour orienter les rayons lumineux issus des sources lumineuses, afin de former le faisceau lumineux de sortie du module optique. La situation est identique pour les feux arrières.

En ce qui concerne les sources, il existe des diodes laser qui peuvent avantageusement remplacer les diodes électroluminescentes pour produire le faisceau lumineux qui servira à former le faisceau d'éclairage et/ou de signalisation de sortie.

Cependant, les faisceaux lasers usuels sont d'une couleur qui ne correspond pas aux couleurs réglementaires de tels projecteurs ou feux arrières. Le module lumineux comporte alors un élément de conversion de longueur d'onde, qui présente une surface de conversion. L'élément de conversion reçoit le faisceau lumineux de la source laser et le réémet, par exemple en lumière blanche, vers le système optique de projection. Ainsi, le faisceau laser n'est pas utilisé directement pour former le faisceau d'éclairage et/ou de signalisation, mais il est d'abord projeté sur l'élément de conversion de longueur d'onde photoluminescent, qui est par exemple de type phosphorescent et/ou fluorescent.

Pour illuminer une zone large de l'élément de conversion avec le faisceau lumineux de la source laser, des moyens de balayage sont nécessaires. Le balayage par le faisceau s'effectue d'un bord à l'autre de la zone de l'élément de conversion, et de préférence à une fréquence suffisamment élevée pour que l'oeil humain ne perçoive pas le mouvement et voit un éclairage continu du faisceau d'éclairage produit par le module lumineux. L'amplitude de balayage définit le déplacement du faisceau lumineux dans l'espace et donc la taille de la zone d'éclairage sur l'élément de conversion.

Les moyens de balayage connus sont par exemple des éléments de type MEMS (pour « Micro-Electro-Mechanical-Systems » en anglais ou microsystèmes électromécaniques), comprenant un ou des micro-miroirs qui réfléchissent le faisceau laser sur la zone. Ces micro-miroirs sont par exemple animés d'au moins un mouvement rotatif autour d'un axe qui engendre le balayage de la zone selon une première direction. Un second micro-miroir ou un autre mouvement rotatif du premier miroir autour d'un second axe perpendiculaire au premier axe permet éventuellement de produire un balayage selon deux directions.

Les dimensions de ces éléments engendrent des contraintes de disposition de chacun d'eux dans le module lumineux. En effet, la distance entre les moyens de balayage et l'élément de conversion définit la taille de la zone balayée par le faisceau lumineux, étant donné que l'amplitude de balayage est dépendante de la configuration des moyens de balayage. On cherche de plus à obtenir une dimension spécifique de l'intersection du faisceau laser avec l'élément de conversion, qu'on appelle cible ou « spot » (point en anglais). Ainsi, c'est le spot qui est balayé sur la zone de l'élément de conversion.

En outre, pour des raisons d'efficacité, il est souhaitable d'illuminer la surface du micro-miroir de manière sensiblement complète (notamment pour que le faisceau ne soit pas concentré sur une zone trop petite du micro-miroir), tout en évitant que le faisceau ne déborde au-delà des bords du micro-miroir, sous peine de brûler les autres éléments constituant les moyens de balayage et de perdre de l'énergie. Idéalement, on touche le bord du miroir lorsque la tâche atteint sa taille maximale. Par conséquent, le faisceau lumineux de la source doit être calibré pour adapter sa largeur aux dimensions des micro-miroirs. Il existe par exemple des moyens de balayage dont les micro-miroirs ont une surface circulaire ou encore d'autres ayant une section allongée, par exemple de 1 mm sur 1,2 mm. Ainsi, il faut obtenir par les moyens optiques des dimensions du faisceau adaptées à ces dimensions différentes. Qui plus est, les sources telles que des diodes laser possèdent un axe rapide et un axe lent. Selon le premier axe, qui est dit « rapide », le faisceau diverge plus fortement que selon le deuxième axe, qui est dit « lent». Autrement dit, le comportement du faisceau laser en champ proche et en champ lointain, n'est pas le même dans les deux directions. En outre la dimension de la face de sortie de la source parallèlement à l'axe lent est différente (plus grande) de la dimension de la face de sortie de la source parallèlement à l'axe rapide. Ainsi, la largeur du faisceau issu de la source laser est plus grande dans la direction de l'axe lent que dans la direction de l'axe rapide proche de la source, et est plus petite dans la direction de l'axe lent que dans la direction de l'axe rapide à grande distance de la source.

Cette différence de vitesse de divergence induit une contrainte supplémentaire dans la définition de la forme du faisceau lumineux à produire.

Toutes ces contraintes doivent être respectées, ce qui implique selon l'état de la technique des formes complexes de lentilles, typiquement des surfaces asphériques ou acylindriques, et un encombrement important des systèmes de focalisation.

Le document US 2018/038558 A1 divulgue un module pour la projection d'un faisceau à balayage selon l'état de l'art.

Un objet de la présente invention est donc de proposer un module amélioré pour la projection d'un faisceau à balayage assurant de bonnes dimensions du faisceau destiné à être balayé, tant au niveau des moyens de balayage qu'au niveau de l'élément de conversion.

D'autres objets, caractéristiques et avantages de la présente invention apparaîtront à l'examen de la description suivante et des dessins d'accompagnement. Il est entendu que d'autres avantages peuvent être incorporés.

RÉSUMÉ DE L'INVENTION

Selon un mode de réalisation, la présente invention prévoit un module lumineux à balayage d'un faisceau lumineux, notamment pour véhicule automobile, comprenant :

- une source lumineuse configurée pour générer un premier faisceau lumineux présentant un axe rapide et un axe lent ;
- un élément de conversion de longueur d'onde comprenant une surface de conversion ;
- un système de focalisation agencé pour produire le faisceau lumineux, comprenant des moyens optiques configurés pour générer un deuxième faisceau lumineux à partir du premier faisceau, et des moyens de balayage générant le faisceau lumineux par réflexion du deuxième faisceau lumineux et agencés pour que le faisceau lumineux balaie la surface de conversion, le système de focalisation étant configuré de sorte que le faisceau lumineux soit focalisé sur la surface de conversion. Avantageusement, le module est tel que les moyens optiques comprennent :
- une lentille de collimation configurée pour produire un faisceau collimaté à partir du premier faisceau ;
- trois dioptres cylindriques non plans disposés après la lentille de collimation suivant un trajet de rayons lumineux depuis la source lumineuse, et comprenant un premier dioptre configuré pour produire une convergence de faisceau seulement suivant l'axe rapide de sorte que, suivant l'axe rapide, la dimension du deuxième faisceau lumineux soit adaptée à celle des moyens de balayage, un deuxième dioptre configuré pour produire une divergence de faisceau seulement suivant l'axe lent, et un troisième dioptre disposé après le deuxième dioptre suivant un trajet des rayons lumineux depuis la source lumineuse, le troisième dioptre étant configuré pour produire une convergence de faisceau seulement suivant l'axe lent, les deuxième et troisième dioptres cylindriques étant configurés pour que, suivant l'axe lent, la dimension du deuxième faisceau soit adaptée à celle des moyens de balayage.

De cette manière, le faisceau à focaliser sur la surface de conversion est mis en forme de manière améliorée, en mettant en oeuvre des surfaces de dioptres de conception et de fabrication aisées, sur la base d'un faisceau issu d'une lentille de collimation. Cette dernière peut être une lentille intégrée à la source lumineuse. Notamment, on peut mettre en oeuvre une source sous forme de diode laser disposant, en son sein, en sortie, d'une lentille de collimation asphérique.

Avantageusement, les deuxième et troisième dioptres cylindriques sont configurés pour que, suivant l'axe lent l'image de la source ait une taille inférieure à une taille donnée au niveau des moyens de conversion. De cette façon, selon l'axe lent, on règle deux paramètres : la taille du faisceau adaptée au moyens de balayage, et le grandissement (car la taille de la source n'est pas négligeable dans cette direction), de sorte que la taille du spot qui arrive sur l'élément de conversion ne soit pas trop grande (pour permettre d'avoir une bonne précision dans le faisceau projeté).

Il est à noter que la définition des faisceaux est déterminante dans un module tel que celui de l'invention dans la mesure où les contraintes sont importantes. En particulier, la surface des moyens de balayage doit être couverte de la manière la plus large possible pour répartir la chaleur au mieux, mais sans laisser le faisceau lumineux déborder de cette surface, pour ne pas détériorer les parties périphériques comme les parties d'entrainement de miroir (aimants, cardan notamment). C'est en ce sens que le faisceau doit être adapté en dimension par le système de focalisation. Dans le même temps, le faisceau reçu par la surface de conversion doit être focalisé au mieux pour la précision du faisceau utile émis, notamment vers l'avant ou vers l'arrière du véhicule. Ces contraintes sont résolues de manière simple et possiblement très compacte, selon l'invention.

De manière facultative, le premier dioptre est disposé entre le deuxième et le troisième dioptres suivant le trajet des rayons lumineux depuis la source lumineuse. Ainsi imbriqués malgré leur fonction différente, les dioptres sont disposés de manière compacte ; les deux dioptres servant à l'axe lent peuvent être suffisamment éloignés pour une divergence suffisante du deuxième dioptre et le premier dioptre est alors intercalé.

Avantageusement, les trois dioptres cylindriques sont portés par trois lentilles distinctes. Il peut s'agir de lentilles plan concave ou plan convexe, avec des formes géométriques simples de nature cylindrique. De préférence, les dioptres plans sont dirigés vers l'aval suivant le trajet des rayons lumineux, de sorte que les trois dioptres cylindriques font face à la source.

Un autre aspect de la présente invention concerne un dispositif lumineux, notamment d'éclairage et/ ou de signalisation pour véhicule automobile, comprenant au moins un module selon l'invention. Ce dispositif peut comprendre un boitier recevant le module et fermé par une glace au travers de laquelle un faisceau de sortie est projeté vers la route, à partir du module, et éventuellement via une optique de projection.

Un autre aspect de l'invention est un véhicule automobile équipé d'au moins un module et/ou d'au moins un dispositif de l'invention.

BRÈVE DESCRIPTION DES FIGURES

Les buts, objets, ainsi que les caractéristiques et avantages de l'invention ressortiront mieux de la description détaillée d'un mode de réalisation de cette dernière qui est illustré par les dessins d'accompagnement suivants dans lesquels :

[Fig. 1] fournit une représentation spatiale d'un module selon l'invention avec une schématisation du trajet suivi par la lumière depuis la source lumineuse jusqu'à une surface de conversion.
[Fig. 2] est une représentation planaire d'un module, dans un plan contenant l'axe optique de la source et son axe rapide.
[Fig. 3] montre la conformation des faisceaux suivant l'axe rapide.
[Fig. 4] est une représentation planaire d'un module, dans un plan contenant l'axe optique de la source et son axe lent.
[Fig. 5] montre la conformation des faisceaux suivant l'axe lent.

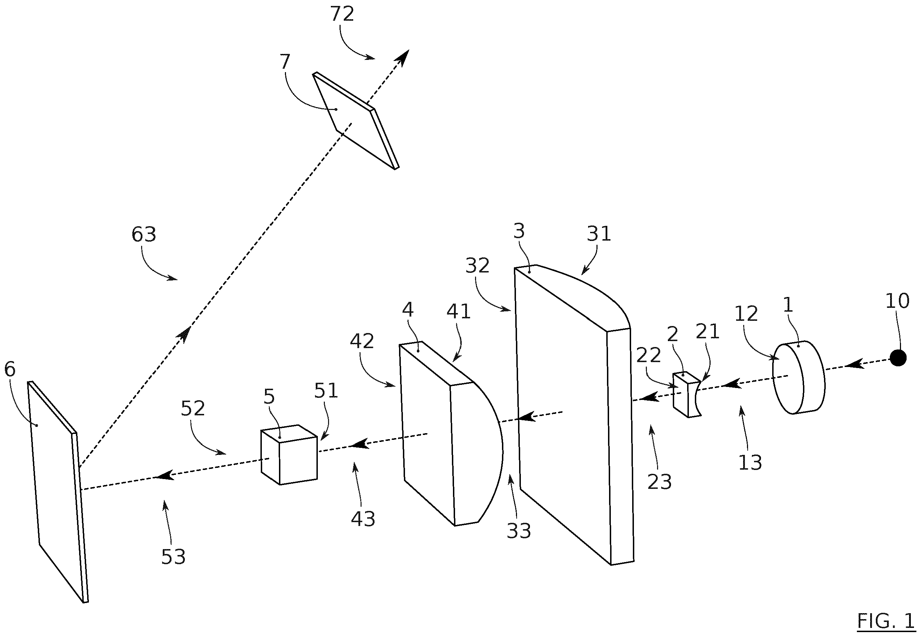

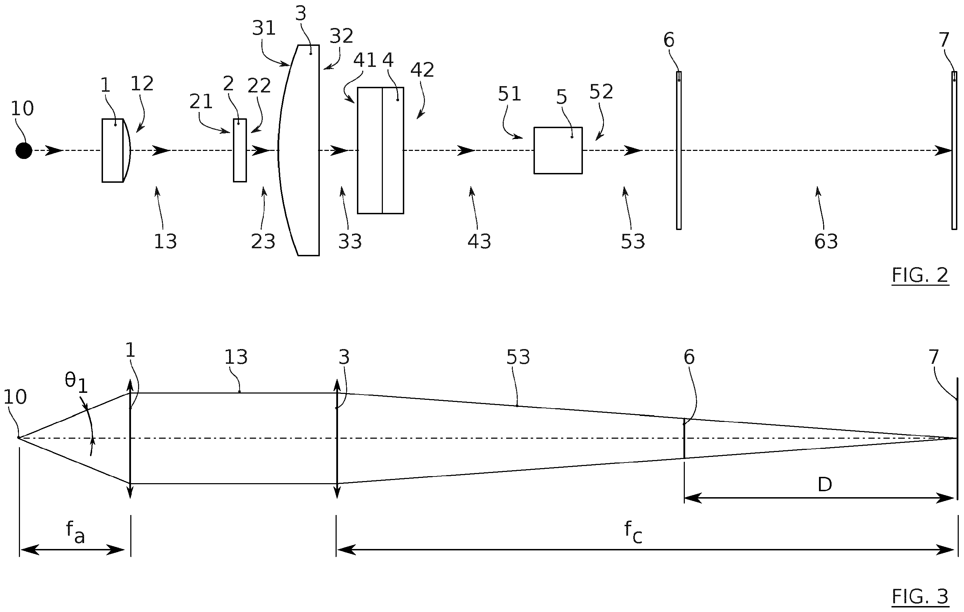

Les dessins sont donnés à titre d'exemples et ne sont pas limitatifs de l'invention. Ils constituent des représentations schématiques de principe destinées à faciliter la compréhension de l'invention et ne sont pas nécessairement à l'échelle des applications pratiques. En particulier, les figures 2 à 5 montrent des représentations dans le plan par simplification, alors que les moyens de balayage modifient en pratique la direction du faisceau de balayage en direction de la surface de conversion, comme le montre la figure 1.

DESCRIPTION DÉTAILLÉE DE L'INVENTION

Avant d'entamer une revue détaillée de modes de réalisation de l'invention, sont énoncées ci-après des caractéristiques optionnelles qui peuvent éventuellement être utilisées en association ou alternativement :

- le premier dioptre 31 est disposé entre les deuxième et troisième dioptres 21, 41 suivant le trajet de rayons lumineux depuis la source lumineuse 10 ;
- la lentille de collimation 1 est une lentille asphérique ;
- la lentille de collimation est formée de manière intégrale avec la source lumineuse ;
- la source lumineuse 10 est une diode laser ;
- celui des trois dioptres 21, 31, 41 cylindriques disposés le plus en amont suivant le trajet des rayons lumineux depuis la source lumineuse 10 est disposé immédiatement après la lentille de collimation 1 ; par « disposé immédiatement après », on entend qu'il n'y a pas d'autres éléments optiques disposés entre la source lumineuse 10 et la lentille de collimation 1 ;
- les trois dioptres 21, 31, 41 cylindriques sont portés par trois lentilles distinctes 2, 3, 4 ;
- les trois dioptres 21, 31, 41 cylindriques sont chacun formé par un dioptre d'entrée des trois lentilles 2, 3, 4 ;
- les trois lentilles 2, 3, 4 présentent chacune un dioptre de sortie plan ;
- les trois lentilles 2, 3, 4 sont immédiatement adjacentes ; par « immédiatement adjacentes », on entend qu'il n'y a pas d'autres éléments optiques disposés entre elles ;
- une deuxième source lumineuse et des deuxièmes moyens optiques sont configurés pour produire un deuxième faisceau additionnel, et le module comporte un élément de combinaison du deuxième faisceau 53 et du deuxième faisceau additionnel en amont des moyens de balayage 6 ;
- l'élément de combinaison comprend un bloc optique 5 d'unification de faisceaux.
- le premier dioptre 31 est agencé de sorte que, suivant l'axe lent, la dimension du deuxième faisceau 53 lumineux soit inférieure ou égale à celle de la surface de balayage ; elle peut par exemple être inférieure de moins de 10%, voire moins de 5% ;
- les deuxième et troisième dioptres 21, 41 cylindriques sont configurés pour que, suivant l'axe rapide, la dimension du deuxième faisceau 53 soit inférieure ou égale à celle de la surface de balayage ; elle peut par exemple être inférieure de moins de 10%, voire moins de 5% ;

- les moyens de balayage 6 comprennent une surface de réflexion du deuxième faisceau 53, de sorte à produire un changement de direction pour former le faisceau lumineux qui va impacter la surface de conversion; les moyens de balayage 6 sont avantageusement munis d'au moins un micro-miroir mobile configuré pour balayer la surface de conversion avec le faisceau lumineux au moins selon une première direction ;
- les trois dioptres 21, 31, 41 cylindriques ont une section en arc de cercle ;
- l'élément de conversion 7 comprend un matériau phosphorescent ;
- le faisceau lumineux généré est un faisceau laser, de préférence produit par une diode laser.

Le module lumineux est notamment utilisable dans un dispositif lumineux, dans un feu arrière ou avant et/ou dans un dispositif d'éclairage intérieur de véhicule automobile.

En figure 1, il comprend une source 10 de lumière, de préférence monochromatique et par exemple cohérente, apte à générer un premier faisceau de lumière qui présente un axe de propagation selon les traits pointillés partant de la source 10, ainsi qu'un axe lent et un axe rapide dirigés selon des directions perpendiculaires entre elles et perpendiculaires à l'axe de propagation. La source est aussi avantageusement configurée pour émettre un faisceau polarisé. La source 10 est ici de préférence une diode laser qui génère un faisceau laser dont les ondes lumineuses ont sensiblement la même valeur de longueur d'onde, par exemple 448 nm pour obtenir une couleur bleue.

Le module lumineux comprend également un élément de conversion 7 de longueur d'onde présentant avantageusement une surface de conversion photoluminescente configurée pour transformer la (ou l'intervalle de) longueur d'onde du faisceau lumineux, qu'elle reçoit, par exemple en étalant la distribution des ondes lumineuses sur des valeurs de longueur d'onde correspondant à des couleurs différentes. Ainsi, on obtient un faisceau 72 réémis au travers de l'élément de conversion avec une autre répartition chromatographique, en particulier dans une autre couleur, par exemple une couleur blanche, à partir du faisceau de lumière initial 63, grâce à l'élément de conversion 7. Suivant une autre possibilité, le faisceau ne traverse pas l'élément de conversion 7 mais le matériau de conversion est disposé sur un miroir de sorte que la lumière convertie et la partie non convertie de la lumière incidente sont réfléchis vers une optique de projection (voire directement vers la glace de sortie dans un feu notamment arrière). L'élément de conversion 7 comprend alors le matériau de conversion et le miroir. Le faisceau lumineux blanc sert par exemple de faisceau d'éclairage dans un dispositif lumineux de véhicule automobile. Le faisceau blanc peut donc être obtenu par la synthèse additive d'une partie de la lumière émise par la source lumineuse 10 et d'une partie de la lumière convertie par l'élément de conversion 7. De préférence le matériau luminescent utilisé est choisi parmi les composés suivants : $Y_3A_{15}O_{12}:Ce^{3+}$ (YAG), $(Sr,Ba)_2SiO_4:Eu^{2+}$, $Ca_x(Si,Al)_{12}(O,N)_{16}:Eu^{2+}$.

Le module lumineux comprend aussi des moyens de balayage 6 de sorte à faire balayer la surface de l'élément de conversion 7 par le faisceau lumineux 62 qui produit un balayage du faisceau 53. Les moyens de balayage 6 sont notamment des éléments de type MEMS (pour « Micro-Electro-Mechanical-Systems » en anglais ou microsystèmes électromécaniques), qui comprennent au moins un micro-miroir. Le micro-miroir est disposé pour interférer avec le faisceau arrivant depuis la source 10. Le micro-miroir réfléchit le faisceau lumineux 53, encore ici appelé deuxième faisceau, vers la surface de conversion de l'élément de conversion 7. Le micro-miroir est de préférence animé d'un mouvement rotatif autour d'un axe qui engendre le balayage de la surface de l'élément de conversion 7. Le balayage par le faisceau 53 s'effectue sur la totalité d'une zone choisie sur la surface de conversion, à une fréquence avantageusement suffisamment importante, par exemple au moins 200 Hz, voire au moins 400 Hz, voire au moins 700 Hz, pour que l'oeil humain ne perçoive pas le mouvement et voit un éclairage continu du faisceau d'éclairage généré par l'élément de conversion 7. Le module lumineux peut comprendre un boitier de protection de l'ensemble, le boitier comprenant une lame transparente ou translucide, par exemple de verre, pour laisser sortir le faisceau final 72.

Le module lumineux comprend en outre un système de focalisation disposé entre la source de lumière 10 et les moyens de balayage 6 pour focaliser le faisceau lumineux, d'une part sur les moyens de balayage 6 de manière à couvrir une grande partie du micro-miroir en évitant de déborder au-delà de sa surface, et afin d'obtenir la focalisation souhaitée sur la surface de conversion de l'élément de conversion 7.

Comme le montre la représentation schématique de la figure 1, le système de focalisation comprend, en aval de la source lumineuse 10, et préférentiellement immédiatement après cette dernière, une lentille de collimation 1. Cette lentille est destinée à produire un faisceau collimaté en direction du reste du système de focalisation. La fonction de collimation peut être fournie par un dioptre de sortie 12 de la lentille 1, et en particulier par une forme sphérique du dioptre 1. De préférence, la lentille 1 est formée de manière intégrale avec la source 10 ; en particulier, certaines diodes laser comportent un système de focalisation optique directement assemblé avec elles, comme c'est le cas de la diode fabriquée par la société Nichia® et portant la référence NUB805. La diode laser en question produit un faisceau divergent polarisé linéairement dans le sens de l'axe lent et la lentille de collimation associée en tire un faisceau résultant qui est un cylindre de base elliptique.

Le faisceau résultant porte le repère 13 sur la figure 1. Compte tenu de la différence de divergence de la source 10 suivant son axe lent et suivant son axe rapide, la forme résultante du faisceau 13 est un cylindre dont la porteuse correspond à l'axe de propagation principale (axe optique de la source) et dont la génératrice a une forme allongée, typiquement elliptique, le grand axe de l'ellipse étant dirigé suivant l'axe rapide.

En suivant le trajet des rayons lumineux depuis la source 10, la lentille 1 est suivie de trois lentilles 2, 3, 4 produisant respectivement des faisceaux 23, 33, 43. Ces lentilles 1, 2, 3, 4 sont avantageusement coaxiales. Il s'agit d'un mode préféré de réalisation, non limitatif, pour porter trois dioptres servant, selon l'invention, à adapter le format de focalisation du faisceau aux contraintes liées à la forme du faisceau sortant de la source (à axe lent et à axe rapide), à la définition du spot sur la surface des moyens de balayage 6 et à la focalisation sur la surface de conversion. Deux dioptres, portant les repères 21 et 41 servent ici à l'adaptation de faisceau uniquement selon l'axe lent, un autre dioptre 31 servant à l'adaptation du faisceau uniquement selon l'axe rapide.

Dans le cas où ces trois dioptres sont chacun porté par une lentille distincte, l'autre dioptre de ces lentilles est avantageusement de forme plane. Dans la mesure où les dioptres 21, 31, 41 peuvent en euxmêmes être de forme géométrique simple (typiquement des forme cylindriques, de section en arc de cercle), on peut donc mettre en oeuvre des lentilles 2, 3, 4 de conception simple, typiquement plan concave ou plan convexe. Avantageusement, les trois dioptres 21, 31, 41 sont dirigés face à la source 10. Dans le cas de la figure 1, les autres dioptres 22,32, 42 des lentilles, plans, sont dirigés face aux moyens de balayage 6.

La fonction des trois dioptres 21, 31, 41 et leur conception est détaillée ci-après.

Les figures 2 et 3 montrent une représentation planaire de l'enchaînement des éléments du module de l'invention, dans un plan comportant l'axe optique du système de focalisation et l'axe rapide de la source 10. Cette dernière est représentée de manière ponctuelle ce qui est proche de la réalité suivant l'axe rapide. Le cône de divergence du faisceau émis par la source 10 est défini par l'angle $\theta_\perp$ visible figure 3. À la figure 2, la section des lentilles 1, 2, 3, 4 est donnée dans le plan considéré. On notera pour autant que seuls les dioptres 12 et 31 ne sont pas optiquement neutres dans ce plan.

La figure 3 représente la transformation du faisceau lumineux depuis la source 10, suivant le plan considéré, en ne retenant, par simplification, que la lentille de collimation 1 et la lentille 3 portant le dioptre 31, encore appelé premier dioptre dans la présente description. Dans les calculs de définition des éléments optiques qui suivent, la lentille 2 n'a ici aucun effet (lame plane à faces parallèles dans le plan du calcul, avec un faisceau incident collimaté perpendiculairement). La lentille 4 et le combineur 5 se comportent également comme des lames à faces planes et parallèles dans le plan du calcul et ont un effet équivalent à l'augmentation correspondante de « l'épaisseur optique » de la lentille 3. Dans un calcul simplifié à lentilles minces, ils n'ont donc pas d'effet mais devront être pris en compte lors du calcul de la lentille réelle. Par contre, lorsqu'on met réellement en place le système, les lentilles ont une certaine épaisseur qui doit avantageusement être prise en compte. Comme vu précédemment, la lentille de collimation 1 permet de collimater le faisceau divergent issu de la source 10. La distance focale $f_a$ sépare la source 10 et la lentille 1. Le faisceau collimaté 13 parvient ensuite jusqu'à la lentille 3 pour subir, au moyen du dioptre 31, une convergence en direction de la surface réfléchissante des moyens de balayage 6. Typiquement, cette convergence est fournie par une forme convexe du dioptre 31.

Il est possible de déterminer la distance appropriée entre l'élément de conversion 7 et la lentille 3 par construction géométrique. En effet, certains paramètres du module sont généralement prédéfinis. C'est le cas par exemple des paramètres $\theta_\perp$ et $f_a$ qui peuvent notamment être fixés par le fabricant de diodes laser intégrant une lentille de collimation. Par ailleurs, la distance D séparant les moyens de balayage 6 et l'élément de conversion 7 peut aussi être fournie ; elle dépend de la surface de l'élément de conversion qu'on souhaite balayer et des angles de débattement maximum des moyens de balayage : on tend à choisir D la plus petite possible pour réduire l'encombre du dispositif tout en balayant la surface souhaitée (et en évitant d'occulter une éventuelle optique de projection située en aval des moyens de conversion dans le cas où lesdits moyens fonctionnent en réflexion). Enfin, la dimension de la surface réfléchissante utile des moyens de balayage, suivant ce plan (c'est-à-dire suivant l'axe rapide) est, elle aussi, déterminée par des données de constructeurs de ce type de dispositif. On appellera $R_{mems}$ la moitié de cette dimension, suivant l'axe rapide. Généralement, elle sera inférieure à la dimension du miroir selon cette direction, dans la mesure où la rotation de ce dernier réduit, en projection dans un plan perpendiculaire à l'axe de propagation du faisceau impactant le miroir, la largeur utilisable ; cette valeur de Rmems sera alors fixée par la demi-largeur totale du miroir et par l'angle maximal de rotation du miroir (c'est le produit du cosinus de l'angle maximal de rotation depuis une position de repos perpendiculaire à l'axe du faisceau à réfléchir et de la demi-largeur du miroir). La lentille 3 se trouve à l'intersection entre le faisceau 13 et le faisceau convergent 53 qui passe avantageusement par le bord de la surface réfléchissante des moyens de balayage 6 (sans dépasser ce bord) et qui est focalisé sur la surface de conversion de l'élément de conversion 7.

La distance focale $f_c$ de la lentille cylindrique 3 séparant la lentille 3 et la surface de l'élément de conversion 7, peut alors être fournie par la formule suivante :

[Math. 1]

$$f_a \tan(\theta_\perp) = f_c \frac{R_{MEMS}}{D}$$

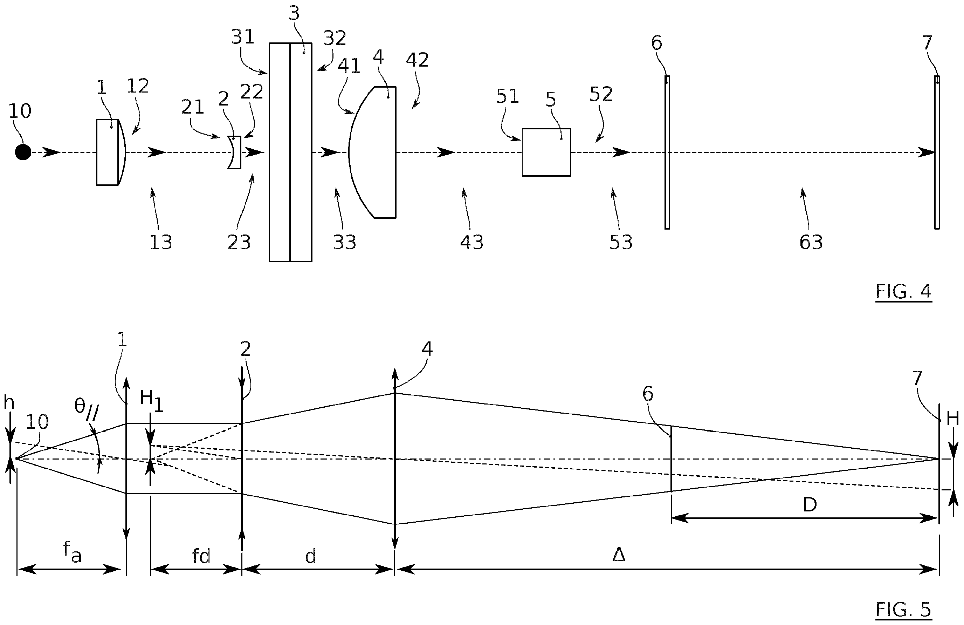

En ce qui concerne l'adaptation de la focalisation suivant l'axe lent, les figures 4 et 5 donnent un exemple de réalisation de manière équivalente à ce qui a été décrit pour l'axe rapide sur la base des figures 2 et 3.

La figure 4 révèle que, dans le plan défini par l'axe optique du système de focalisation et par l'axe lent, la lentille 3 est optiquement neutre alors que le dioptre 12 de la lentille 1, le dioptre 21 de la lentille 2 et le dioptre 41 de la lentille 4 modifient successivement le faisceau lumineux. De manière équivalente à la lentille 2 suivant l'autre direction, les lentilles 1 et 3 sont ici considérées comme dans effet suivant cet axe, pour le calcul ; dans un calcul simplifié à lentilles minces, ces éléments n'ont donc pas d'effet mais devront être pris en compte lors du calcul de la lentille réelle. Par contre, lorsqu'on met réellement en place le système, les lentilles ont une certaine épaisseur qui doit avantageusement être prise en compte. La lentille 1 produit la collimation déjà décrite sur la base du faisceau divergent issu de la source lumineuse 10 et correspondant au cône d'angle $\theta_{//}$ visible en figure 5. Dans le plan considéré, le faisceau collimaté a une largeur moindre, correspondant à l'axe lent de la diode laser. Comme précédemment, fa représente la distance entre le dioptre 12 de la lentille 1 est la source 10. Suivant cette orientation, l'objet initial est de taille non négligeable, contrairement au plan précédent, en référence aux figures 2 à 3. Ainsi, suivant l'axe lent, il faut tenir compte du grandissement de l'optique car la source est beaucoup plus allongée suivant cet axe, suivant un mode de réalisation préféré de l'invention.

À cet effet, outre l'utilisation d'un dioptre 41, ici porté par la lentille 4, ayant un effet convergent en direction des moyens de balayage 6, on met en oeuvre un dioptre 21 ayant un effet divergent, ici porté par la lentille 2, servant à augmenter la section du faisceau 33 au niveau de la lentille 4 dans le plan de la figure, afin que l'intersection du cône issu du spot sur les moyens de conversion et passant par les bords des moyens de balayage dans le plan de la figure et du cône issu de la lentille 2, intersection qui détermine la position de la lentille 4, se trouve en amont des moyens de balayage et du combineur optionnel. On tient avantageusement compte du fait que le faisceau impactant les moyens de balayage ne doit pas en déborder, tout en restant aussi large que possible, tout en notant que le débattement angulaire de la surface réfléchissante des moyens de balayage implique aussi une réduction de la taille de la tâche du faisceau sur les moyens de balayage (on tient compte du cosinus de l'angle de débattement à cet effet).

Ainsi, dans le plan considéré aux figures 4 et 5, des lentilles sont mises en oeuvre pour opérer l'adaptation de forme du faisceau. De préférence, comme le montre la figure 4, la lentille 3 précédemment discutée pour son action suivant l'axe rapide est intercalée entre les deux lentilles 2 et 4 servant à l'axe lent.

On notera que l'utilisation de trois lentilles distinctes permet l'emploi de moyens optiques peu onéreux et de géométrie simple. Cependant, l'invention n'exclut pas d'utiliser un nombre différent de lentilles, et notamment de faire porter deux des trois dioptres par une seule lentille.

Les éléments géométriques représentés sur la figure 5 expliquent une méthode de détermination de la position des lentilles 2 et 4. Comme précédemment pour l'axe rapide, des paramètres seront généralement connus/fixés par construction, et en particulier les suivants :

- angle $\theta_{//}$
- distance $f_a$ ;
- $R'_{mems}$; cette valeur tient de préférence compte du débattement du miroir, et peut être obtenue, comme suivant l'axe rapide (voir le calcul de $R_{mems}$ ci-dessus);
- hauteur de la source h, moitié de longueur de la source suivant l'axe lent ;
- distance D ;
- hauteur de l'image de la source sur la surface de conversion H, moitié de la dimension maximale du spot ;
- distance $\Delta$ de la lentille 4 aux moyens de conversion en suivant un rayon confondu avec l'axe optique, choisie de manière à être la plus proche possible des moyens de balayage (pour minimiser l'encombrement total du dispositif), tout en respectant les contraintes géométriques dues aux dimensions mécaniques du système de balayage et à l'implantation d'une deuxièmes branche de focalisation couplée grâce à l'élément 5;

En appelant par ailleurs $f_d$ la distance focale de la lentille divergente 2, $g_1$ le grandissement de la lentille divergente 2 et $g_2$ le grandissement de la lentille convergente 4, ainsi que d la distance séparant lesdites lentilles 2 et 4, et $H_1$ la hauteur de l'image virtuelle de la source 10 par la lentille divergente 2, et en notant $f'_c$ la distance focale de la lentille convergente, on peut écrire :

[Math. 2]

$$\frac{H_1}{f_d} = \frac{h}{f_a} \implies g_1 = \frac{f_d}{f_a}$$

[Math. 3]

$$\frac{H}{\triangle} = \frac{H_1}{d + f_d} => \quad g_2 = \frac{\triangle}{d + f_d}$$

[Math. 4]

$$f_c' = \frac{\Delta \cdot (d + f_d)}{(d + f_d) + \Delta}$$

[Math. 5]

$$\frac{\frac{f_a \, \tan(\theta_{//})}{f_d}(f_d + d)}{\Delta} D < R'_{mems}$$

[Math. 6]

$$g_1 \cdot g_2 \leqslant \frac{H}{h}$$

Les deux dernières inégalités permettent de choisir d et fd et donc d'en déduire f'c, ce qui finalement détermine les caractéristiques et le positionnement relatif des lentilles minces, en approximation, des lentilles 2 et 3.

La distance △ ayant été choisie, les positions des lentilles 2 et 4 sont déterminées par rapport aux moyens de conversion et de balayage, comme l'est la position de la lentille 3 par le calcul de fc. La distance de la source à la première lentille étant imposée par le tirage (distance entre la source et la face d'entrée de la lentille (le tirage est égal à la focale uniquement si on a une lentille mince)) de la lentille 1, une seule distance reste indéterminée : la distance entre la lentille 1 et la lentille 2 qui peut être choisie arbitrairement et est en général choisie la plus petite possible compte tenu des contraintes d'intégration mécanique et notamment de l'éventuel dispositif de réglage de focalisation prévu dans le système. Suivant un mode de réalisation non limitatif, le module de l'invention comprend également des moyens permettant une unification des faisceaux issus de deux sources lumineuses distinctes, de sorte à former un faisceau résultant global plus puissant en direction des moyens de balayage 6. À cet effet, un exemple de réalisation schématisé aux figures 1, 2 et 4 consiste à utiliser un diviseur de faisceaux polarisés utilisé en sens inverse, c'est-à-dire pour recevoir deux faisceaux distincts (le faisceau 53, et un autre faisceau de polarisation perpendiculaire de préférence obtenu en mettant en oeuvre des moyens identiques à ceux précédemment décrits pour générer le faisceau 53, comprenant une source lumineuse telle une diode laser à lentille de collimation et un système de focalisation à trois dioptres d'adaptation de faisceau suivant les axes lent et rapide) et les combiner en une sortie unique. En prenant l'exemple de la figure 1, le faisceau additionnel (non représenté) entrerait dans le bloc 5 latéralement, suivant une direction parallèle à l'axe lent. Le bloc 5 est typiquement un séparateur de faisceaux polarisants doté de deux portions prismatiques recevant chacune un des deux faisceaux lumineux et qui, par renvoi d'angle par réflexion de l'un des deux faisceaux entrant à l'interface des prismes, produit un faisceau 53 combiné en sortie, en direction des moyens de balayage. Il n'est pas exclu que ce principe de faisceau additionnel et de combinaison de faisceaux soit reproduit plus d'une fois, avec au moins une autre source et un autre système produisant un autre faisceau additionnel, et un autre bloc de combinaison de faisceaux. Cela peut se faire, non pas par polarisation, mais par multiplexage avec des longueurs d'onde différentes (avec un miroir dichroïque). Le séparateur laissera passer une première longueur d'onde et réfléchira une seconde longueur d'onde.

L'invention n'est pas limitée aux modes de réalisation précédemment décrits et s'étend à tous les modes de réalisation couverts par les revendications.

**Revendications**

1. Module lumineux à balayage d'un faisceau lumineux (63), notamment pour véhicule automobile, comprenant :

- une source lumineuse (10) configurée pour générer un premier faisceau lumineux (13) présentant un axe rapide et un axe lent ;

- un élément de conversion (7) de longueur d'onde comprenant une surface de conversion ;
- un système de focalisation agencé pour produire le faisceau lumineux (63), comprenant

  - des moyens optiques comprenant une lentille de collimation (1) configurée pour produire un faisceau collimaté (13) à partir du premier faisceau et configurés pour générer un deuxième faisceau lumineux (53) à partir du premier faisceau (13), et
  - des moyens de balayage (6) générant le faisceau lumineux par réflexion du deuxième faisceau lumineux (53) et agencés pour que le faisceau lumineux (63) balaie la surface de conversion, le système de focalisation étant configuré de sorte que le faisceau lumineux (63) soit focalisé sur la surface de conversion,

  **caractérisé en ce que** les moyens optiques comprennent :- trois dioptres (21, 31, 41) cylindriques non plans disposés après la lentille de collimation (1) suivant un trajet de rayons lumineux depuis la source lumineuse, et comprenant un premier dioptre (31) configuré pour produire une convergence de faisceau seulement suivant l'axe rapide de sorte que, suivant l'axe rapide, la dimension du deuxième faisceau lumineux (53) soit adaptée à celle des moyens de balayage (6), un deuxième dioptre (21) configuré pour produire une divergence de faisceau seulement suivant l'axe lent, et un troisième dioptre (41) disposé après le deuxième dioptre (21) suivant un trajet des rayons lumineux depuis la source lumineuse (10), le troisième dioptre (41) étant configuré pour produire une convergence de faisceau seulement suivant l'axe lent, les deuxième et troisième dioptres (21, 41) cylindriques étant configurés pour que, suivant l'axe lent, la dimension du deuxième faisceau (53) soit adaptée à celle des moyens de balayage (6).

2. Module selon la revendication précédente, dans lequel le premier dioptre (31) est disposé entre les deuxième et troisième dioptres (21, 41) suivant le trajet de rayons lumineux depuis la source lumineuse (10).

3. Module selon l'une des revendications précédentes, dans lequel la lentille de collimation (1) est une lentille asphérique.

4. Module selon l'une des revendications précédentes, dans lequel la lentille de collimation (1) est formée de manière intégrale avec la source lumineuse (10).

5. Module selon l'une des revendications précédentes, dans lequel la source lumineuse (10) est une diode laser.

6. Module selon l'une des revendications précédentes, dans lequel celui des trois dioptres (21, 31, 41) cylindriques disposés le plus en amont suivant le trajet des rayons lumineux depuis la source lumineuse (10) est disposé immédiatement après la lentille de collimation (1).

7. Module selon l'une quelconque des revendications précédentes, dans lequel les trois dioptres (21, 31, 41) cylindriques sont portés par trois lentilles (2, 3, 4) distinctes.

8. Module selon la revendication précédente, dans lequel les trois dioptres (21, 31, 41) cylindriques sont chacun formé par un dioptre d'entrée des trois lentilles (2, 3, 4).

9. Module selon la revendication précédente, dans lequel les trois lentilles présentent chacune un dioptre de sortie plan.

10. Module selon l'une des revendications 7 à 9, dans lequel les trois lentilles (2, 3, 4) sont immédiatement adjacentes.

11. Module selon l'une des revendications précédentes, comprenant une deuxième source lumineuse et des deuxièmes moyens optiques configurés pour produire un deuxième faisceau additionnel, et un élément de combinaison du deuxième faisceau (53) et du deuxième faisceau additionnel en amont des moyens de balayage (6).

12. Module selon la revendication précédente, dans lequel l'élément de combinaison comprend un bloc optique (5) d'unification de faisceaux.

13. Dispositif lumineux, notamment d'éclairage et/ ou de signalisation pour véhicule automobile, comprenant au moins un module selon l'une des revendications précédentes

**Patentansprüche**

1. Lichtmodul mit Abtastung eines Lichtbündels (63), insbesondere für ein Kraftfahrzeug, umfassend:

   - eine Lichtquelle (10), die dazu ausgestaltet ist, ein erstes Lichtbündel (13) zu generieren, das eine schnelle Achse und eine langsame Achse aufweist;
   - ein Wellenlängenkonversionselement (7) das eine Konversionsfläche umfasst;
   - ein Fokussierungssystem, das dazu eingerichtet ist, das Lichtbündel (63) zu erzeugen, umfassend
   - optische Mittel, die eine Kollimationslinse (1) umfassen, die dazu ausgestaltet ist, ein kollimiertes Bündel (13) ausgehend von dem ersten Bündel zu erzeugen, und dazu ausgestaltet sind, ein zweites Lichtbündel (53) ausgehend von dem ersten Bündel (13) zu generieren, und
   - Abtastmittel (6), die das Lichtbündel durch Reflexion des zweiten Lichtbündels (53) generieren und dazu eingerichtet sind, dass das Lichtbündel (63) die Konversionsfläche abtastet, wobei das Fokussierungssystem so ausgestaltet ist, dass das Lichtbündel (63) auf die Konversionsfläche fokussiert wird,

   **dadurch gekennzeichnet, dass** die optischen Mittel umfassen:- drei nicht plane zylindrische Diopter (21, 31, 41), die hinter der Kollimationslinse (1) entlang eines Lichtstrahlengangs von der Lichtquelle aus angeordnet sind, und umfassend einen ersten Diopter (31), der dazu ausgestaltet ist, eine Bündelkonvergenz nur entlang der schnellen Achse zu erzeugen, so dass entlang der schnellen Achse das Maß des zweiten Lichtbündels (53) an das der Abtastmittel (6) angepasst ist, einen zweiten Diopter (21), der dazu ausgestaltet ist, eine Bündeldivergenz nur entlang der langsamen Achse zu erzeugen, und einen dritten Diopter (41), der hinter dem zweiten Diopter (21) entlang eines Lichtstrahlengangs von der Lichtquelle (10) aus angeordnet ist, wobei der dritte Diopter (41) dazu ausgestaltet ist, eine Bündelkonvergenz nur entlang der langsamen Achse zu erzeugen, wobei die zweiten und dritten zylindrischen Diopter (21, 41) dazu ausgestaltet sind, dass entlang der langsamen Achse das Maß des zweiten Bündels (53) an das der Abtastmittel (6) angepasst ist.

2. Modul nach dem vorhergehenden Anspruch, wobei der erste Diopter (31) zwischen dem zweiten und dem dritten Diopter (21, 41) entlang des Lichtstrahlengangs von der Lichtquelle (10) aus angeordnet ist.

3. Modul nach einem der vorhergehenden Ansprüche, wobei die Kollimationslinse (1) eine asphärische Linse ist.

4. Modul nach einem der vorhergehenden Ansprüche, wobei die Kollimationslinse (1) einstückig mit der Lichtquelle (10) gebildet ist.

5. Modul nach einem der vorhergehenden Ansprüche, wobei die Lichtquelle (10) eine Laserdiode ist.

6. Modul nach einem der vorhergehenden Ansprüche, wobei derjenige der drei zylindrischen Diopter (21, 31, 41), der am weitesten stromauf entlang des Lichtstrahlengangs von der Lichtquelle (10) aus angeordnet ist, unmittelbar hinter der Kollimationslinse (1) angeordnet ist.

7. Modul nach einem der vorhergehenden Ansprüche, wobei die drei zylindrischen Diopter (21, 31, 41) von drei verschiedenen Linsen (2, 3, 4) getragen werden.

8. Modul nach dem vorhergehenden Anspruch, wobei die drei zylindrischen Diopter (21, 31, 41) jeweils durch einen Eintrittsdiopter der drei Linsen (2, 3, 4) gebildet werden.

9. Modul nach dem vorhergehenden Anspruch, wobei die drei Linsen jeweils einen planen Austrittsdiopter aufweisen.

10. Modul nach einem der Ansprüche 7 bis 9, wobei die drei Linsen (2, 3, 4) unmittelbar benachbart sind.

11. Modul nach einem der vorhergehenden Ansprüche, umfassend eine zweite Lichtquelle und zweite optische Mittel, die dazu ausgestaltet sind, ein zusätzliches zweites Bündel zu erzeugen, und ein Element zur Kombination des zweiten Bündels (53) und des zusätzlichen zweiten Bündels stromauf der Abtastmittel (6).

12. Modul nach dem vorhergehenden Anspruch, wobei das Element zur Kombination einen optischen Block (5) zur Vereinigung von Bündeln umfasst.

13. Leuchtvorrichtung, insbesondere zur Beleuchtung und/oder Signalisierung für ein Kraftfahrzeug, die mindestens ein Modul nach einem der vorhergehenden Ansprüche umfasst.

**Claims**

1. A luminous module with a scanning light beam (63), said module in particular being for a motor vehicle, and comprising:

   - a light source (10) configured to generate a first light beam (13) having a fast axis and a slow axis;
   - a wavelength-converting element (7) comprising a conversion surface;
   - a focusing system arranged to produce the light beam (63), comprising

       - optical means comprising a collimating lens (1) configured to produce a collimated beam (13) from the first beam and configured to generate a second light beam (53) from the first beam (13), and
       - scanning means (6) that generate the light beam by reflection of the second light beam (53) and that are arranged so that the light beam (63) scans the conversion surface, the focusing system being configured so that the light beam (63) is focused on the conversion surface,

   **characterized in that** the optical means comprise:

   - three non-planar cylindrical dioptric interfaces (21, 31, 41) placed after the collimating lens (1) on a path of light rays from the light source, and comprising a first dioptric interface (31) configured to produce a beam convergence only along the fast axis so that, along the fast axis, the dimension of the second light beam (53) is tailored to the dimension of the scanning means (6), a second dioptric interface (21) configured to produce a beam divergence only along the slow axis, and a third dioptric interface (41) placed after the second dioptric interface (21) on a path of the light rays from the light source (10), the third dioptric interface (41) being configured to produce a beam convergence only along the slow axis, the second and third cylindrical dioptric interfaces (21, 41) being configured so that, along the slow axis, the dimension of the second beam (53) is tailored to the dimension of the scanning means (6).

2. The module as claimed in the preceding claim, wherein the first dioptric interface (31) is placed between the second and third dioptric interfaces (21, 41) on the path of light rays from the light source (10).

3. The module as claimed in one of the preceding claims, wherein the collimating lens (1) is an aspherical lens.

4. The module as claimed in one of the preceding claims, wherein the collimating lens (1) is integrally formed with the light source (10).

5. The module as claimed in one of the preceding claims, wherein the light source (10) is a laser diode.

6. The module as claimed in one of the preceding claims, wherein that of the three cylindrical dioptric interfaces (21, 31, 41) placed most upstream along the path of the light rays from the light source (10) is placed immediately after the collimating lens (1).

7. The module as claimed in any one of the preceding claims, wherein the three cylindrical dioptric interfaces (21, 31, 41) are borne by three distinct lenses (2, 3, 4).

8. The module as claimed in the preceding claim, wherein the three cylindrical dioptric interfaces (21, 31, 41) are each formed by an entrance dioptric interface of the three lenses (2, 3, 4).

9. The module as claimed in the preceding claim, wherein the three lenses each have a planar exit dioptric interface.

10. The module as claimed in one of claims 7 to 9, wherein the three lenses (2, 3, 4) are immediately adjacent.

11. The module as claimed in one of the preceding claims, comprising a second light source and second optical means configured to produce an additional second beam, and an element for combining the second beam (53) and the additional second beam upstream of the scanning means (6).

**12.** The module as claimed in the preceding claim, wherein the combining element comprises an optical unit (5) for unifying beams.

**13.** A luminous device, in particular for motor-vehicle lighting and/or signaling, comprising at least one module as claimed in one of the preceding claims.

EP 3 959 467 B1

FIG. 1

FIG. 2

FIG. 3

FIG. 4

FIG. 5

EP 3 959 467 B1

**RÉFÉRENCES CITÉES DANS LA DESCRIPTION**

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- US 2018038558 A1